(19) Europäisches Patentamt
European Patent Office
Office européen des brevets

(11) **EP 3 308 399 B1**

(12) **FASCICULE DE BREVET EUROPEEN**

(45) Date de publication et mention
de la délivrance du brevet:
**26.05.2021  Bulletin 2021/21**

(21) Numéro de dépôt: **16731044.0**

(22) Date de dépôt: **07.06.2016**

(51) Int Cl.:
***H01L 27/146*** *(2006.01)*

(86) Numéro de dépôt international:
**PCT/EP2016/062902**

(87) Numéro de publication internationale:
**WO 2016/198402 (15.12.2016 Gazette 2016/50)**

(54) **CAPTEUR D'IMAGE A HAUTE DYNAMIQUE, A NOEUD DE STOCKAGE EN TROIS PARTIES**

BILDSENSOR MIT HOHEM DYNAMIKBEREICH UND DREITEILIGEM SPEICHERKNOTEN

WIDE-DYNAMIC IMAGE SENSOR, WITH THREE-PART STORAGE NODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **12.06.2015  FR 1555372**

(43) Date de publication de la demande:
**18.04.2018  Bulletin 2018/16**

(73) Titulaire: **Teledyne e2v Semiconductors SAS**
**38120 Saint-Egrève (FR)**

(72) Inventeurs:
• **MAYER, Frédéric**
**38500 Voiron (FR)**
• **FEREYRE, Pierre**
**38340 Voreppe (FR)**
• **GESSET, Stéphane**
**38380 Saint Laurent Du Pont (FR)**

(74) Mandataire: **Marks & Clerk France**
**Immeuble "Visium"**
**22, avenue Aristide Briand**
**94117 Arcueil Cedex (FR)**

(56) Documents cités:
**EP-A1- 1 868 377       FR-A1- 2 961 631**
**US-A1- 2006 284 051    US-A1- 2009 032 852**
**US-A1- 2012 132 787**

EP 3 308 399 B1

**Description**

L'invention concerne les capteurs d'image électronique à matrice de pixels actifs.

Ces capteurs utilisent un réseau de pixels en lignes et en colonnes, avec dans chaque pixel un élément photosensible et plusieurs transistors.

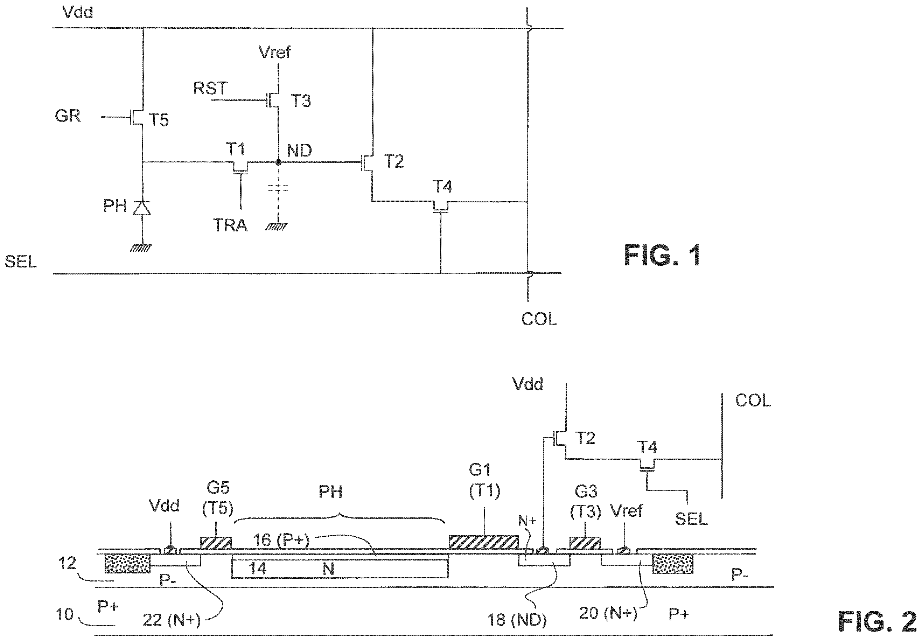

Une constitution avantageuse du pixel est une constitution telle que représentée à la figure 1, avec :

- une photodiode PH autopolarisée (en anglais : pinned photodiode),
- un nœud de stockage de charges ND, qui est l'équivalent d'une capacité, et qui est en pratique constitué par une région semiconductrice dopée à potentiel flottant,
- un transistor de transfert T1 pour isoler la photodiode du nœud de stockage ou au contraire autoriser un transfert de charges de la photodiode vers le nœud de stockage en vue de mesurer le potentiel du nœud de stockage après ce transfert,
- un transistor T2 de lecture de charges, monté en suiveur de tension, ayant sa grille reliée au nœud de stockage pour permettre de reporter le potentiel du nœud de stockage sur la source du transistor,
- un transistor T3 de réinitialisation du nœud de stockage, permettant de porter à une valeur de référence le potentiel du nœud de stockage avant ou après une mesure des charges présentes dans le nœud, en vue d'une mesure différentielle des potentiels du nœud de stockage en présence de charges issues de la photodiode et en l'absence de charges issues de la photodiode ;
- un transistor T4 de sélection de pixel, commandé par un conducteur SEL d'adressage en ligne, permettant de reporter sur un conducteur de colonne COL le potentiel de la source du transistor de lecture T2 ; le conducteur de ligne SEL est commun à tous les pixels d'une même ligne de pixels ; le conducteur de colonne COL est commun à tous les pixels d'une même colonne de pixels,
- enfin, un transistor supplémentaire T5, facultatif, qui peut avoir l'une et/ou l'autre des deux fonctions suivantes : évacuer les charges électriques en excédent dans la photodiode en cas d'éclairement trop fort, ou bien réinitialiser le potentiel de la photodiode en vidant complètement les charges accumulées afin qu'elle reprenne son potentiel à vide avant de débuter une nouvelle période d'intégration.

On notera qu'on utilise l'appellation "transistor" pour faciliter la compréhension en termes de schéma électrique tel que le schéma de la figure 1. Toutefois, dans la constitution physique du pixel, ces transistors ne sont pas nécessairement tous constitués de manière classique, indépendamment des autres éléments du pixel, avec une région de source, une région de drain, une région de canal séparant la source du drain et une grille isolée au-dessus du canal. Dans la constitution physique réelle du pixel, certains transistors sont en réalité constitués essentiellement par une grille isolée à laquelle on peut appliquer un potentiel de commande. Ainsi, par exemple, le transistor de transfert T1 est constitué par une simple grille de transfert G1 isolée du substrat, surmontant une région de canal de type P qui est située entre la photodiode PH et une diffusion de type N+ constituant le nœud de stockage de charges ; la source du transistor T1 est la photodiode ; le drain du transistor est le nœud de stockage de charges. De même : la source du transistor T3 peut-être la région dopée constituant le nœud de stockage ; la source du transistor T5 peut-être la région de type N de la photodiode qui accumule des charges générées par la lumière.

Ainsi, la figure 2 représente en coupe la constitution physique du pixel, formé dans un substrat semiconducteur 10, par exemple de type P+. Le substrat comporte à sa partie supérieure une couche active semiconductrice 12 de type P- dans laquelle se déplacent les électrons.

La photodiode PH est constituée par une région 14 de type N diffusée dans la couche active de type P-. La couche 14 est de préférence recouverte par une région superficielle 16 de faible profondeur de type P+, plus dopée que la couche active et portée au potentiel du substrat et de la couche active, qu'on considérera ci-après comme une référence de potentiel nul. Du fait de cette région superficielle P+ au potentiel de référence nul, la photodiode est une photodiode auto-polarisée (pinned photodiode en anglais), en ce sens que son potentiel interne intrinsèque (potentiel interne ou potentiel à vide, en l'absence de charges photogénérées) est fixé uniquement par la technologie et plus précisément par les concentrations en impuretés des zones de type N et P et les épaisseurs de ces zones.

Le nœud de stockage de charges ND est constitué par une diffusion flottante 18 de type N+ dans la couche active. Un contact est pris à sa partie supérieure pour une connexion à la grille du transistor de lecture T2, représenté symboliquement sur la figure 2.

Le transistor de transfert T1 est constitué par une grille de transfert isolée G1 disposée au-dessus d'une portion de la couche active 12, entre la région de photodiode 14 et la diffusion flottante18 constituant le nœud de stockage.

Le transistor T3 de réinitialisation du nœud de stockage est constitué par une grille isolée G3 située au-dessus de la couche active 12, entre la diffusion 18 et une autre diffusion 20 de type N+ qui constitue un drain porté à un potentiel de réinitialisation Vref.

Le transistor facultatif T5 de réinitialisation de la photodiode est constitué par une grille isolée G5 située au-dessus de la couche active entre la photodiode PH (régions diffusées 14, 16) et une diffusion 22 de type N+ qui constitue un drain porté à un potentiel de référence Vdd qui peut être le potentiel d'alimentation du capteur et qui peut être ou non le même que le potentiel de réinitialisation Vref.

Enfin, la constitution physique du transistor de lecture T2 et du transistor de sélection T4 n'est pas représentée sur la figure 2. Le transistor T2 est constitué par une région de source, une région de drain, et entre les deux une grille isolée ; la région de source est une diffusion de type N+ qui sert également de région de drain pour le transistor de sélection T4 ; la région de drain du transistor T2 est une diffusion de type N+ qui est portée à un potentiel d'alimentation qui peut être encore le potentiel Vdd ; la grille est reliée par un conducteur au nœud de stockage ND. Le transistor T4 comprend, outre son drain de type N+, une région de source qui est une diffusion N+ reliée au conducteur de colonne COL, et une grille qui est reliée au conducteur de ligne SEL.

La photodiode est entourée d'une barrière d'isolement, à l'exception de l'endroit où elle est adjacente au canal du transistor T1 et de l'endroit où elle est adjacente au canal du transistor T5. Cette barrière entoure par ailleurs l'ensemble du pixel pour l'isoler des autres pixels ; elle peut être constituée par une région profonde de type P+, ou par une couche enterrée en matériau isolant (oxyde de silicium notamment) ; elle est représentée symboliquement par une région à surface pointillée à droite et à gauche du pixel. Cette barrière d'isolement peut, si elle est en contact avec la couche superficielle 16 de type P+ et avec la couche active, servir à mettre la couche 16 au potentiel de référence nul.

Le pixel qui vient d'être décrit fonctionne en accumulant dans la région N de la photodiode des charges créées dans la couche active par l'éclairement du pixel pendant un temps d'intégration ; au cours de ce temps, le transistor T1, bloqué, empêche les charges de la photodiode de sortir de la photodiode vers le nœud de stockage ND.

A la fin du temps d'intégration, la grille G1 du transistor T1 est activée par un signal TRA pour autoriser le transfert des charges de la photodiode vers le nœud de stockage ND.

Les charges transférées sont lues lors de la sélection du pixel par le transistor de sélection T4. A ce moment, le transistor de lecture T2 transfère sur le conducteur de colonne le potentiel du nœud de stockage, potentiel dont la valeur résulte de la quantité de charges présentes dans le nœud de stockage. Un circuit de lecture en pied de colonne mesure ce potentiel.

Le potentiel qui est lu dépend d'un facteur quantitatif qui est le facteur de conversion charge-tension appelé ci-après CVF (de l'anglais Charge to Voltage conversion Factor). Ce facteur est déterminé par la valeur de la capacité existant entre le nœud de stockage de charges et la masse (capacité représentée sur la figure 1 en pointillés) et par le gain $g_{T2}$ du transistor suiveur T2. La masse est la référence de potentiel de la couche active de type P- qui constitue l'anode de la photodiode.

Le facteur de conversion CVF est égal à l'inverse de la capacité $C_{ND}$ du nœud de stockage, que multiplie le gain $g_{T2}$ du transistor suiveur T2. En effet, une variation

$\Delta Q$ de charge électrique dans le nœud de stockage engendre directement une variation de potentiel $\Delta V = \Delta Q/C_{ND}$ du nœud de stockage, le facteur de conversion étant $(\Delta V/\Delta Q).g_{T2}$.

$$CVF = g_{T2} \times 1/C_{ND}$$

Ce facteur de conversion limite la dynamique du capteur pour la raison suivante : pour les très faibles éclairements, il faut obtenir une tension suffisante pour que la chaîne de mesure en aval puisse mesurer cette tension avec un bruit suffisamment faible, faute de quoi la mesure n'aurait pas de sens. Par exemple, pour un éclairement ne produisant que quelques dizaines d'électrons dans la photodiode, il faut que ces quelques dizaines d'électrons produisent au moins quelques milliers de microvolts. On cherche en pratique à obtenir un facteur de conversion proche de 100 microvolts par électron, ce qui nécessite une très faible capacité, de l'ordre de 0,002 picofarad.

Mais alors, l'éclairement mesuré ne peut pas être trop élevé, car la chaîne de mesure, pour un capteur alimenté avec une tension d'environ 3 volts, ne peut pas accepter une tension à mesurer supérieure à 1,5 volts environ. Avec une capacité de 0,002 picofarad produisant un facteur de conversion d'environ 100 microvolts par électron, on ne peut pas mesurer un éclairement produisant plus de 15 000 électrons.

On a déjà proposé des solutions pour faire fonctionner le pixel avec deux facteurs de conversion différents selon le niveau d'éclairement, afin de stocker des charges dans un nœud de stockage de plus grande capacité (donc de plus faible facteur de conversion) lorsque l'éclairement est élevé, et dans un nœud de stockage de plus faible capacité lorsque l'éclairement est plus faible.

La demande de brevet US 2013/0001404 en décrit un exemple, utilisant deux grilles de transfert, l'une des deux servant en partie de nœud de stockage de charges. D'autres publications, US 2007/257280, US 20140103189, EP 2346079, décrivent des tentatives pour obtenir une dynamique plus élevée que dans l'art antérieur pour les forts éclairements.

La demande EP 1868377 propose une structure de pixel à deux capacités de stockage supplémentaire pour récupérer les charges qui débordent de la photodiode pendant la phase d'intégration.

L'invention a pour but de proposer une solution originale pour accroître la dynamique de mesure d'éclairements vers les forts éclairements, sans détériorer la dynamique vers les faibles éclairements.

L'invention propose un capteur d'image comprenant une matrice de pixels actifs, chaque pixel comprenant une photodiode à potentiel interne intrinsèque fixe, un nœud de stockage pour un stockage de charges intégrées dans la photodiode, au moins une grille de transfert de charges entre la photodiode et le nœud de stockage pour commander le transfert de charges de la photodiode vers le nœud de stockage après une phase de réinitialisation du nœud de stockage, une grille de réinitialisation du potentiel du nœud de stockage, et une connexion électrique entre le nœud de stockage et la grille d'un transistor de lecture, pour permettre une mesure du potentiel du nœud de stockage pendant une phase de lecture suivant le transfert de charges, caractérisé en ce que le nœud de stockage comporte trois parties comprenant :

- une première diffusion flottante adjacente à la grille de transfert et à la grille de réinitialisation, et reliée par la connexion électrique à la grille du transistor de lecture,
- une deuxième diffusion flottante, non adjacente à la première diffusion flottante, non adjacente à la grille de réinitialisation, non reliée à la connexion électrique,
- une structure de fixation de potentiel interne, séparant la première diffusion flottante de la deuxième diffusion flottante, cette structure établissant un plateau de potentiel interne en l'absence de charges entre les deux diffusions flottantes et dans la deuxième diffusion flottante, à un niveau de potentiel intermédiaire fixe pendant la phase de lecture, supérieur au potentiel interne intrinsèque fixe de la photodiode mais inférieur à un niveau de potentiel de réinitialisation de la première diffusion flottante, de sorte que les charges déversées depuis la photodiode dans le nœud de stockage soient confinées dans la première diffusion flottante mais débordent spontanément, si elles sont trop nombreuses, dans la structure de fixation de potentiel interne et dans la deuxième diffusion flottante.

De préférence, une capacité auxiliaire faisant partie du pixel est reliée par une connexion électrique à la deuxième diffusion flottante ; cette capacité auxiliaire a de préférence une valeur de capacité par unité de surface supérieure à la capacité par unité de surface de chacune des diffusions flottantes. En effet, cette capacité auxiliaire va servir à stocker des charges en cas d'éclairement fort et il est souhaitable qu'elle puisse recueillir une quantité de charges élevée sans augmenter trop la surface du pixel. La capacité auxiliaire est de préférence localisée au-dessus du nœud de stockage (première et/ou deuxième diffusion flottante) ; elle peut être constituée par des électrodes, soit superposées sur deux niveaux de couche conductrice, soit interdigitées dans un même niveau de couche conductrice.

La deuxième diffusion flottante et la capacité auxiliaire éventuellement raccordée à cette deuxième diffusion servent à recueillir des charges au-delà de la quantité de charges que peut recueillir la première diffusion flottante, cette dernière quantité étant essentiellement le produit de la capacité de la première diffusion flottante par la différence entre le potentiel de réinitialisation de la première diffusion flottante et le potentiel intermédiaire de la structure formant barrière de potentiel entre les deux diffusions flottantes.

On expliquera plus loin en détail le fonctionnement du pixel mais on peut dire en résumé qu'une opération de réinitialisation de la première diffusion flottante vide de leurs charges les deux diffusions flottantes et la capacité auxiliaire éventuellement présente. Le potentiel interne de la première diffusion flottante s'établit à une valeur dictée par la tension appliquée à cette première diffusion flottante. Le potentiel interne de la deuxième diffusion flottante s'établit au potentiel interne de la structure formant barrière de potentiel. Le transfert de charges vers le nœud de stockage s'effectue exclusivement vers la première diffusion flottante si la quantité de charges est faible. Seule la capacité de la première diffusion flottante intervient alors dans le facteur de conversion charge tension. Ce facteur est élevé. Si la quantité de charges est plus importante et fait déborder la première diffusion flottante, les charges en excès passent dans la deuxième diffusion flottante et dans la capacité auxiliaire éventuellement présente. Le facteur de conversion résulte alors de la somme des capacités, c'est-à-dire la somme des capacités des deux diffusions flottantes, de la capacité de la structure formant barrière de potentiel et de la capacité auxiliaire éventuellement présente. Le facteur de conversion devient donc beaucoup plus faible.

Dans une variante de réalisation, la grille de transfert de charges est composée d'une succession d'au moins deux grilles de transfert entre la photodiode et le nœud de stockage, la première grille de transfert étant adjacente à la photodiode et la dernière grille de transfert étant adjacente à la première diffusion flottante, et le capteur comporte des moyens pour appliquer séparément aux différentes grilles de transfert des potentiels de commande, pour d'abord autoriser un transfert de charges de la photodiode vers la première diffusion flottante par activation des deux grilles de transfert, puis élever une barrière de potentiel d'abord sous la première grille de transfert et enfin élever une barrière de potentiel sous la dernière grille de transfert. Cette disposition permet, comme on le verra plus loin, de stocker dans les trois parties du nœud de stockage une quantité de charges qui peut faire monter le potentiel du nœud de stockage au-dessus du potentiel interne intrinsèque de la photodiode, ce qui ne serait pas possible avec une seule grille de transfert.

On peut de plus prévoir que la grille de transfert est composée d'une succession de trois grilles de transfert entre la photodiode et le nœud de stockage, la première grille de transfert étant adjacente à la photodiode et la troisième grille de transfert étant adjacente à la première diffusion flottante, et la deuxième grille de transfert étant située entre la première et la troisième grille de transfert ; le capteur comporte des moyens pour appliquer séparément aux différentes grilles de transfert des potentiels de commande, pour d'abord autoriser par la première grille de transfert un transfert de charges de la photodiode vers une zone située sous la deuxième grille de transfert, puis établir une barrière de potentiel sous la première grille de transfert, puis successivement autoriser le transfert de charges de la zone située sous la deuxième grille vers la première diffusion flottante, et enfin élever une barrière de potentiel sous la deuxième puis la troisième grilles de transfert. Cette disposition permet que le capteur fonctionne en mode de "global shutter", c'est-à-dire de transfert de charges simultané pour tous les pixels, tout en autorisant, pour les faibles éclairements, une lecture par double échantillonnage corrélé véritable. Par double échantillonnage corrélé véritable, on entend qu'on fait une lecture d'un niveau de potentiel du nœud de stockage après réinitialisation du nœud de stockage mais avant transfert de charges dans le nœud réinitialisé, et on fait ensuite la différence de ces deux lectures.

La structure de fixation de potentiel interne est de préférence une diode auto-polarisée (pinned diode), de structure semblable à la photodiode mais avec un niveau de potentiel interne intrinsèque (en l'absence de charges) supérieur à celui de la photodiode. Alternativement, cette structure peut être une simple grille isolée au-dessus de la couche active, entre les deux diffusions flottantes. Le niveau de potentiel intermédiaire de la barrière est alors ajusté par action sur le potentiel appliqué à cette grille isolée.

D'autres caractéristiques et avantages de l'invention apparaîtront à la lecture de la description détaillée qui suit et qui est faite en référence aux dessins annexés dans lesquels :

- la figure 1 représente le schéma électrique d'un pixel classique ;
- la figure 2 représente en coupe la structure physique d'un pixel tel que celui de la figure 1 ;
- la figure 3 représente en coupe la structure physique d'un pixel selon l'invention ;
- la figure 4 représente un chronogramme temporel de fonctionnement du pixel ;
- la figure 5 représente un diagramme des potentiels dans le semiconducteur au cours du fonctionnement ;
- la figure 6 représente en coupe la structure physique du pixel dans une variante de réalisation ;
- la figure 7 représente un chronogramme temporel de fonctionnement du pixel de la figure 6 ;
- la figure 8 représente un diagramme d'évolution des potentiels au cours du fonctionnement du pixel de la figure 6 ;
- la figure 9 représente en coupe la structure physique du pixel dans une autre variante de réalisation ;
- la figure 10 représente un chronogramme temporel de fonctionnement du pixel de la figure 9 ;
- la figure 11 représente un diagramme d'évolution des potentiels au cours du fonctionnement du pixel de la figure 9.

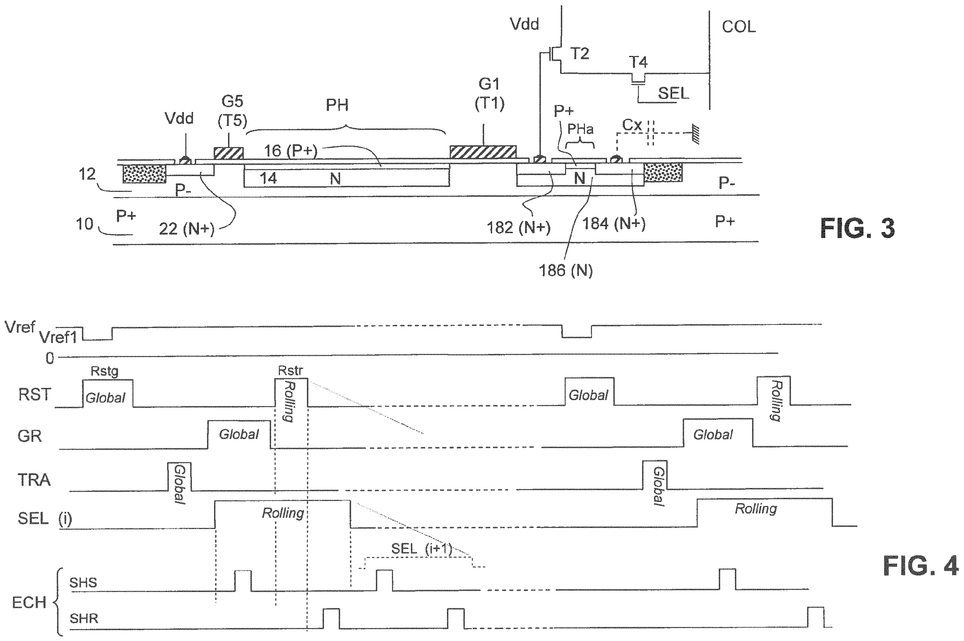

La figure 3 représente en coupe le pixel selon l'invention qui se distingue du pixel de la figure 2 par le fait que le nœud de stockage temporaire de charges ND comporte maintenant trois parties au lieu d'une seule diffusion flottante N+ dans la couche active. On fera attention au fait que pour faciliter les explications, on n'a pas représenté sur la figure 3 les éléments suivants qui existent comme sur la figure 2 mais qui doivent être considérés comme étant dans un autre plan de coupe : il s'agit de la grille de réinitialisation G3 au-dessus d'une portion de couche active de type P, et du drain 20 de type N+ avec son contact relié à un potentiel de référence Vref servant à la réinitialisation. Le plan de coupe utilisé pour la figure 3 est un plan qui traverse les trois parties du nœud de stockage et qui ne traverse pas la grille de réinitialisation G3 et son drain 20. Comme à la figure 2, les transistors de lecture T2 et de sélection de ligne T4 ne sont représentés que symboliquement.

Le nœud de stockage ND comporte maintenant les trois parties juxtaposées suivantes :

- une première diffusion flottante 182 de type N+ adjacente à la grille de transfert G1 et à la grille de réinitialisation non représentée G3, et reliée par un contact électrique superficiel à une connexion électrique qui rejoint la grille du transistor de lecture T2 ;
- une deuxième diffusion flottante 184 de type N+, non adjacente à la première diffusion flottante 182, non adjacente à la grille de réinitialisation G3, non reliée à la grille de T2, et adjacente ou non à la grille de transfert G1 ; les diffusions 182 et 184 sont dites flottantes car elles ne sont pas reliées (sauf pendant des instants de réinitialisation) à une circuiterie qui fixe leur potentiel ; leur potentiel varie en fonction des charges électriques qui y sont déversées ;
- une structure PHa de fixation de potentiel interne, cette structure séparant la première diffusion flottante de la deuxième diffusion flottante de sorte que ces deux régions diffusées ne se touchent pas ; cette structure établit (en l'absence de charges électriques dans le nœud de stockage) un plateau de potentiel dans la couche semiconductrice active entre les deux diffusions flottantes.

Dans l'exemple de la figure 3, la structure de fixation de potentiel PHa est constituée comme une diode auto-polarisée, c'est-à-dire qu'elle comprend une diode PN dont l'anode est la couche active 12, la cathode est une région 186 de type N diffusée dans la couche active 12 de type P, avec en outre une région superficielle de type P+ recouvrant la diffusion 186 de type N et portée à un potentiel de référence qui est de préférence mais pas obligatoirement le potentiel de référence nul de la couche active.

Sur la figure 3, on a représenté la diffusion N 186 comme s'étendant aussi au-dessous des diffusions flottantes 182 et 184 bien que ce ne soit pas obligatoire ; il est plus facile de diffuser la région N dans les trois parties du nœud de stockage que dans la structure PHa seulement et la région N 186 ne perturbe pas les deux diffusions flottantes 182 et 184 de type N+.

La structure PHa de diode auto-polarisée, semblable à la structure de la photodiode PH, en diffère cependant en ce que le potentiel interne intrinsèque de cette structure en l'absence de charges a une valeur Vpin2 supérieure à la valeur du potentiel interne intrinsèque Vpin1 de la photodiode. Ceci est important, comme on le verra, pour permettre que toutes les charges de la photodiode se déversent dans le nœud de stockage.

Le potentiel interne intrinsèque est déterminé par la structure technologique, c'est-à-dire principalement les valeurs de dopage et les épaisseurs des zones diffusées N et P+. Il dépend également de la géométrie, plus précisément des dimensions de la structure en raison des effets de bord lorsque ces dimensions sont très faibles. On sait donc régler le potentiel Vpin2 à une valeur supérieure à Vpin1.

Le potentiel interne Vpin2 ainsi fixé est inférieur au potentiel VH de réinitialisation de la première diffusion flottante, celui-ci étant fixé par la valeur Vref appliquée à cette diffusion flottante au moment de la réinitialisation du nœud flottant du pixel. Vpin2 est donc un potentiel intermédiaire entre le potentiel interne intrinsèque Vpin1 de la photodiode et le potentiel VH que prend la première diffusion flottante lors de la réinitialisation.

On verra que la deuxième diffusion flottante 184 constitue une capacité permettant de stocker des charges en supplément de celles qui peuvent être stockées dans la première diffusion flottante. Les charges qui peuvent être stockées en supplément dépendent évidemment de la valeur de la capacité de cette deuxième diffusion flottante. Pour une meilleure efficacité de l'invention, on prévoit de préférence que la deuxième diffusion flottante est reliée par un contact électrique à une capacité auxiliaire Cx propre au pixel et dont la valeur de capacité par unité de surface est significativement plus importante que celle de la deuxième diffusion flottante. La capacité auxiliaire est représentée de manière symbolique sur la figure 3 en pointillés ; elle peut être réalisée en pratique à partir de couches conductrices et isolantes situées au-dessus du nœud de stockage, soit à partir de deux niveaux d'armatures superposées soit à partir d'armatures interdigitées formées dans un seul niveau de couche conductrice (aluminium ou autre).

Ainsi, on peut réduire au minimum la surface de la deuxième diffusion flottante, et la limiter à la surface nécessaire pour prendre un contact électrique, tout en ayant une capacité de stockage de charges beaucoup plus importante que si seule la deuxième diffusion flottante était utilisée comme capacité de stockage pour les charges qui ne peuvent pas être stockées dans la première diffusion flottante.

On va maintenant, en référence à la figure 4, donner un séquencement typique du fonctionnement du pixel selon l'invention.

Le séquencement est donné ici dans un mode dit "global shutter" ou obturation globale, dans lequel tous les pixels intègrent des charges générées par la lumière pendant une même durée, avec un même point de départ de cette durée. Cependant, le pixel peut aussi fonctionner dans un mode dit "rolling shutter", ou obturation défilante, dans lequel les pixels intègrent des charges pendant la même durée mais avec un décalage progressif, de ligne à ligne, du point de départ de cette durée. Dans les deux cas, la lecture des pixels après la fin de la durée d'intégration se fait de manière défilante ("rolling"), ligne par ligne.

Le séquencement est périodique, avec une période de trame fixe ou réglable.

L'activation du signal GR réinitialise la photodiode en la vidant de ses charges vers le drain 22 par mise en conduction du transistor T5. Le front de descente du signal de réinitialisation GR définit le début de l'intégration des charges dans la photodiode sous l'effet de la lumière. La fin de la durée d'intégration est définie ensuite par le front de descente du signal de transfert TRA ; le signal TRA est le signal qui rend conducteur le transistor T1 et qui permet le transfert de charges de la photodiode vers le nœud de stockage ND.

Avant l'application du signal de transfert TRA, le nœud de stockage ND a été réinitialisé par un premier signal de réinitialisation Rstg appliqué à la grille G3. Il est ainsi vidé des charges résultant de la période d'intégration précédente.

Le signal GR, le signal Rstg, et le signal TRA sont des signaux globaux, appliqués simultanément à toute la matrice de pixels, dans ce mode "global shutter".

La lecture des pixels de la matrice, par des circuits de lecture placés en pied de colonne, commence après la fin du signal TRA, c'est-à-dire lorsque tous les nœuds de stockage ont reçu les charges des photodiodes respectives. Pendant cette lecture, l'intégration de charges dans les photodiodes peut très bien recommencer ; en effet, l'intégration commence à la fin du signal GR, et cette fin est indépendante de l'opération de lecture et elle peut avoir lieu avant, pendant, ou après l'opération de lecture. Le réglage de la durée d'intégration se fait en positionnant le front de descente de GR plus ou moins tôt avant le signal TRA. Les circuits de lecture en pied de colonne comprennent des circuits d'échantillonnage et des circuits de conversion analogique-numérique des échantillons. Il y a de préférence un circuit d'échantillonnage et un circuit de conversion associés à chaque colonne et ces circuits travaillent tous en parallèle.

La lecture se fait ligne par ligne, de manière défilante (ou "rolling"), en appliquant à une seule ligne à la fois un signal SEL qui rend conducteur les transistors T4 de tous les pixels d'une même ligne. Le signal SEL, rolling, reporte sur le conducteur de colonne associé à un pixel le niveau de potentiel présent sur la source du transistor suiveur T2, qui lui-même recopie le niveau de potentiel présent sur la première diffusion flottante 182 à laquelle sa grille est connectée.

La durée du signal SEL pour une ligne donnée est suffisante pour permettre :

- d'échantillonner par un signal SHS (en pied de colonne) le niveau de signal utile représentant l'éclairement,
- de réinitialiser le nœud de stockage par un signal Rstr qui, contrairement au signal global Rstg est un signal de type "rolling", appliqué uniquement à la ligne de pixels lue et pas aux autres,
- d'échantillonner par un signal SHR (en pied de colonne) le niveau de réinitialisation du nœud de stockage reporté par le signal SEL sur le conducteur de colonne,

La conversion analogique-numérique des échantillons ainsi lus sur le conducteur de colonne se fait soit en deux étapes (conversion du niveau de signal utile puis conversion du niveau de réinitialisation et soustraction des résultats numériques) ou en une seule étape (conversion en numérique d'une différence analogique des deux échantillons).

Après la fin du signal SEL correspondant à la première ligne, est émis un signal SEL sur la deuxième ligne, et ainsi de suite, la lecture se terminant après le signal SEL correspondant à la dernière ligne.

Enfin, on prévoit de préférence que le signal de réinitialisation global Rstg appliqué à la grille G3 du transistor T3 est synchronisé avec une évolution de la tension de référence qui est appliquée au drain 20 de ce transistor (Figure 2) pendant la réinitialisation : dans une première phase dite "hard reset", la tension appliquée au drain est d'abord plus faible que sa valeur nominale Vref, et plus faible que la tension appliquée à la grille, puis, dans une deuxième phase dite "soft reset", elle prend sa valeur nominale Vref. On expliquera plus loin l'avantage de cette réinitialisation en deux étapes.

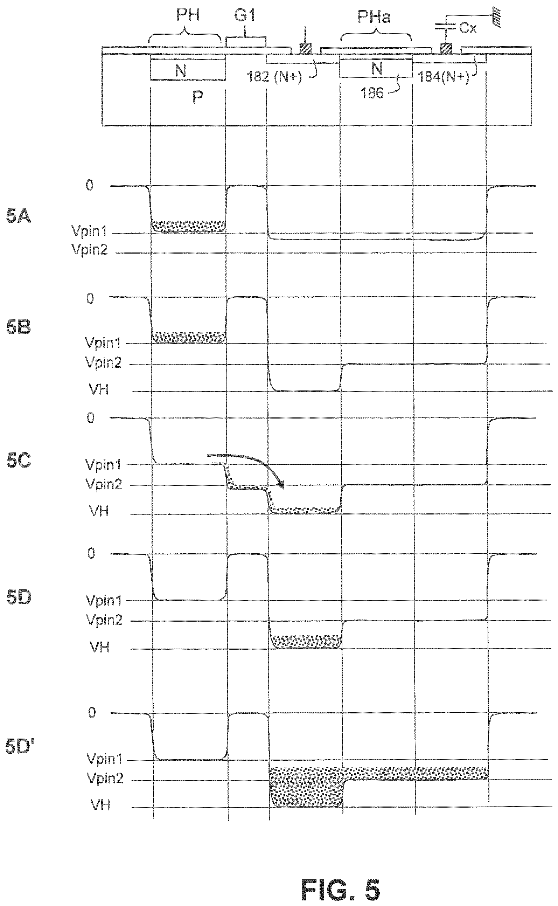

La figure 5 représente un diagramme des potentiels dans les différentes régions du pixel, pour les différentes étapes d'un cycle périodique d'intégration, et en envisageant deux cas qui sont respectivement un cas de faible éclairement, donc de faible accumulation de charges dans la photodiode, et un cas de plus fort éclairement. Le diagramme de potentiel est placé au-dessous des zones correspondantes du pixel, redessinées schématiquement sur la figure 5.

Les diagrammes de potentiel sont définis avec les potentiels croissants vers le bas pour permettre une représentation des écoulements et stockages de charges électriques selon une analogie hydraulique, tenant compte du fait que les charges sont négatives (électrons).

On se place après une phase d'intégration de charges dans la photodiode, qui fait descendre le potentiel de la photodiode au-dessous de son potentiel interne intrinsèque Vpin1, en proportion de la quantité de charges intégrées, et on considère d'abord la réinitialisation globale du nœud de stockage par le signal Rstg.

Dans la phase 5A, qui est une phase de "hard reset" du nœud de stockage, on applique d'abord à la première diffusion flottante, à partir du drain 20 du transistor T3, un premier potentiel de réinitialisation Vref1 inférieur au potentiel Vpin2 de la structure PHa. Ce potentiel Vref1 sera généralement supérieur au potentiel interne Vpin1 de la photodiode, sans que cela constitue une contrainte sévère, puisque dans cette phase de "hard reset" 5A, le nœud de stockage est isolé de la photodiode (par le transistor T1). Le potentiel de commande de la grille du transistor T3, égal par exemple à Vdd, est supérieur à ce potentiel de réinitialisation Vref1. Les charges éventuellement présentes dans le nœud de stockage se vident dans le drain 20 ; le potentiel de la structure PHa et le potentiel des deux diffusions flottantes prennent une valeur définie par la tension de "hard reset" (Vref1) appliquée à ce moment au drain du transistor de réinitialisation T3.

Dans la phase 5B, on exécute la deuxième phase de réinitialisation, en mode "soft reset", avec un potentiel Vref supérieur à Vref1 et par exemple égal à Vdd, sur le drain du transistor T3. Il en résulte dans la couche active semiconductrice la création d'un puits de potentiel dans la première diffusion flottante, puits dont le fond est à un potentiel haut VH défini en fonction de cette tension de réinitialisation Vref. On choisit Vref pour que le potentiel VH soit supérieur au potentiel interne intrinsèque Vpin2 de la structure PHa qui lui-même est supérieur au potentiel interne intrinsèque Vpin1 de la photodiode.

Le puits de potentiel ne s'étend pas à la deuxième diffusion flottante qui ne touche pas la première et qui ne reçoit pas la tension Vref. Il ne s'étend pas non plus sous la diode auto-polarisée PHa. Mais le potentiel interne de la deuxième diffusion flottante 184 s'aligne sur le potentiel interne intrinsèque de la diode PHa, c'est-à-dire Vpin2. Le potentiel interne Vpin2 en l'absence de charges de la deuxième diffusion flottante et de la diode auto-polarisée PHa reste alors fixe pendant toute la durée de la phase de lecture qui suit cette phase de réinitialisation.

Dans la phase 5C, on abaisse la barrière de potentiel précédemment fermée par la grille de transfert G1, pour permettre le transfert de charges de la photodiode vers le nœud de stockage.

Les charges électriques accumulées dans la photodiode se déversent dans le puits de potentiel de la première diffusion flottante.

Les courbes 5D et 5D' montrent les diagrammes de potentiel après ce déversement et après la fin de la mise en conduction du transistor de transfert T1 donc après remontée de la barrière de potentiel qui borde la photodiode. Pour la courbe 5D, il s'agit d'une hypothèse où les charges intégrées sont en faible quantité, de sorte qu'elles ne débordent pas du puits de potentiel créé sous la première diffusion. Dans la phase de lecture ligne par ligne qui suit, le facteur de conversion charge-tension CVF est élevé ; il ne résulte que de la capacité (faible) de la première diffusion flottante. Inversement, dans l'hypothèse de la courbe 5D', les charges générées par la lumière ont été plus nombreuses et elles débordent spontanément vers les deux autres parties du nœud de stockage : structure PHa et deuxième diffusion flottante. Les charges se répartissent alors entre les différentes capacités qui se trouvent en parallèle : capacité de la première diffusion flottante, capacité de la deuxième diffusion flottante, capacité de la structure PHa, et capacité auxiliaire Cx. Tout accroissement ΔQ de charges déversées se traduit par une baisse de potentiel ΔQ/C où C est la somme de ces quatre capacités. Le facteur de conversion peut être beaucoup plus faible, spécialement grâce à la capacité auxiliaire Cx qui peut être une capacité à forte densité, c'est-à-dire à forte capacité par unité de surface si on la compare à la capacité par unité de surface de la première diffusion flottante. On peut donc mesurer à la fois de faibles éclairements avec un fort facteur de conversion et des forts éclairements avec un faible facteur de conversion, et ceci d'une manière automatique, c'est-à-dire sans action spécifique pour modifier volontairement le facteur de conversion.

Dans ce qui précède, on a considéré que le pixel comporte un transistor T5 pour la réinitialisation globale de la photodiode. Ce transistor est toutefois facultatif et on peut faire la réinitialisation de la photodiode à travers le transistor T1 et le transistor T3 rendus simultanément conducteurs. Un signal spécifique TRA' (non représenté) rend le transistor T1 conducteur pendant une mise en conduction du transistor T3. La fin du signal TRA' définit le début d'une durée d'intégration. La fin du signal TRA définit la fin de la durée d'intégration.

Dans le séquencement décrit en référence à la figure 4, on a considéré un fonctionnement en mode global shutter. Un fonctionnement en mode rolling shutter est possible, en supprimant le transistor T5 ou en ne le commandant plus, et en inversant l'ordre des opérations de réinitialisation Rstr et de transfert TRA pour une ligne de pixels considérée. L'intégration se fait ligne par ligne et le signal TRA devient un signal de type "rolling". Pour une ligne de pixels sélectionnée par le signal SEL, on effectue dans l'ordre les opérations suivantes : réinitialisation du nœud de stockage par le signal Rstr appliqué à cette ligne seulement ; échantillonnage par le signal SHR du niveau réinitialisé, transfert de charges de la photodiode vers le nœud de stockage pour la ligne considérée seulement (signal TRA en mode rolling et non global) ; échantillonnage du niveau de signal utile par le signal SHS. Et mesure du niveau utile par différence (corrélée) des deux échantillons avant ou après numérisation. Ce séquencement en mode rolling shutter a l'avantage de permettre une mesure par double échantillonnage corrélé qui réduit le bruit de lecture de type kTC, mais il a l'inconvénient de rendre plus difficile le réglage de la durée d'intégration et l'inconvénient d'avoir une exposition non synchrone des différentes lignes puisqu'il faut prévoir un décalage de départ d'exposition de ligne à ligne.

La structure de fixation du potentiel interne PHa peut être constituée non pas d'une diode auto-polarisée (diffusion N dans la couche active P, surmontée d'une diffusion superficielle P+ à potentiel nul ou fixe) mais constituée plutôt d'une simple grille isolée, disposée au-dessus de la couche active et portée à un potentiel choisi. Le potentiel appliqué à cette grille est choisi pour fixer le potentiel interne du semiconducteur entre les deux diffusions flottantes 182 et 184 à une valeur intermédiaire entre le potentiel interne intrinsèque Vpin1 de la photodiode et le potentiel VH du fond du puits de potentiel de la première diffusion flottante 182. On peut désigner par Vpin2 cette valeur intermédiaire, par analogie avec la valeur du potentiel interne intrinsèque de la diode auto-polarisée, car elle joue le même rôle. Là encore, le potentiel interne Vpin2 en l'absence de charges de la deuxième diffusion flottante et de la région sous cette grille reste alors fixe pendant toute la durée de la phase de lecture qui suit la phase de réinitialisation. La quantité de charges qu'on peut stocker en mode de faible éclairement est proportionnelle à la différence VH-Vpin2 et à la valeur de la capacité de la première diffusion flottante. La quantité de charges supplémentaires qu'on peut stocker en mode de fort éclairement est proportionnelle à la différence Vpin2-Vpin1 mais proportionnelle aussi à la somme des capacités du nœud de stockage (trois parties) et de la capacité auxiliaire Cx.

On remarquera que la deuxième diffusion flottante peut avoir une surface très réduite dans le cas où il y a une capacité auxiliaire Cx, car sa capacité propre intervient alors très peu par rapport à la valeur de la capacité auxiliaire Cx. La surface de la deuxième diffusion flottante peut se limiter à la surface nécessaire pour prendre un contact électrique vers la capacité auxiliaire.

Il est intéressant de noter qu'un des intérêts de la réinitialisation du nœud de stockage en deux phases (hard reset suivi de soft reset) est de réduire les risques d'erreur de rétablissement du niveau de potentiel de réinitialisation qui seraient dus à une injection dite thermoionique. Ce risque concerne le cas où un faible éclairement est mesuré dans un pixel : le potentiel sous la première diffusion flottante après déversement de charges de la photodiode est supérieur à Vpin 2 ; mais le potentiel dans la structure adjacente PHa est Vpin2 ; des électrons générés par l'activité thermique naturelle du silicium dans la structure PHa ou dans la deuxième diffusion flottante pendant l'opération de lecture de la matrice peuvent être attirés vers le puits de potentiel qui n'est pas rempli jusqu'à Vpin2 ; ces électrons, extraits de la deuxième diffusion flottante, tendent à augmenter le potentiel de celle-ci, créant une poche de potentiel sous la deuxième diffusion flottante. En procédant d'abord à une phase de hard reset, on comble cette poche, rétablissant le potentiel sous les trois parties du nœud de stockage à une même valeur, cette valeur étant cependant inférieure à Vpin2 car le potentiel de réinitialisation en hard reset est inférieur à Vpin2. Puis on procède à la phase de soft reset, avec un potentiel Vref plus élevé, qui ramène le potentiel sous la structure PHa et sous la deuxième diffusion flottante à la valeur Vpin2 et qui ramène le potentiel sous la première diffusion flottante à la valeur VH.

Dans un perfectionnement de l'invention, on prévoit que la grille de transfert G1 est composé d'au moins deux grilles successives entre la photodiode et la première diffusion flottante, avec des moyens pour commander séparément l'activation de ces deux grilles. Le but est d'augmenter encore la capacité de stockage de charges en présence d'un fort éclairement, en évitant de limiter à Vpin2-Vpin1 la différence de potentiel maximale générée par les charges résultant d'un fort éclairement.

En effet, comme on le voit sur le diagramme de la figure 5C, on ne pourrait pas déverser de la photodiode des charges qui abaisseraient le potentiel du nœud de stockage au-dessous de Vpin1, une marche de potentiel étant nécessaire entre la photodiode et le nœud de stockage pour que les charges continuent à se déverser.

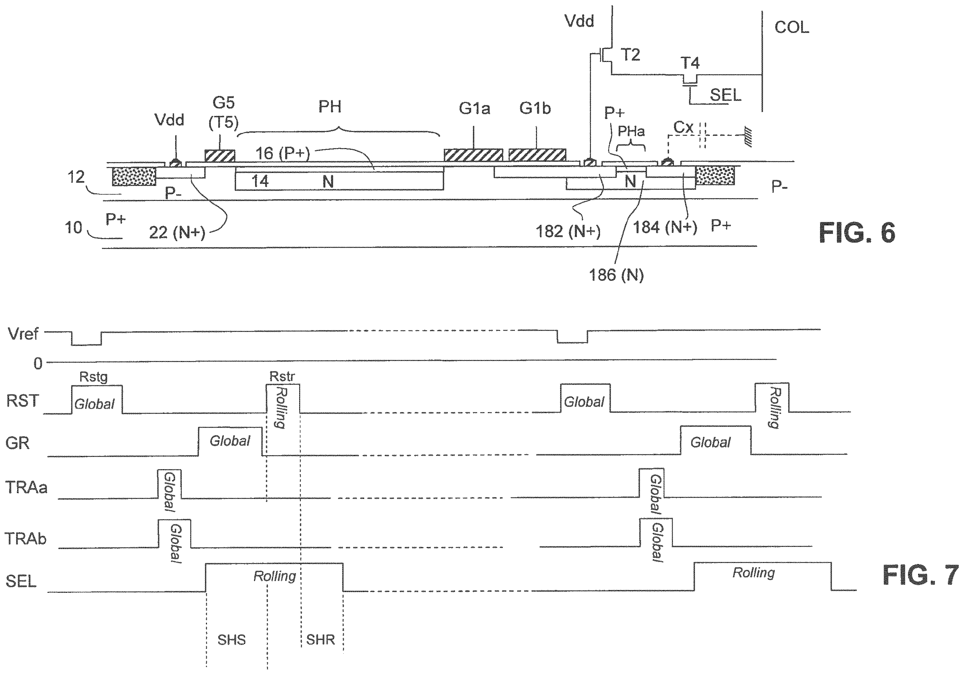

La figure 6 représente une structure de pixel à double grille de transfert qui permet d'aller au-delà de cette quantité. La double grille de transfert comprend deux grilles adjacentes qui sont la première grille G1a, adjacente à la photodiode, et la deuxième grille G1b adjacente à la première diffusion flottante 182. Les autres éléments du pixel sont les mêmes que ceux de la figure 3. De plus, la diffusion flottante 182, de type N+ s'étend sous la totalité de la deuxième grille G1b (mais pas sous la grille G1a ou en tous cas pas sous la partie de grille G1a adjacente à la photodiode), de sorte que des charges venant de la photodiode et suffisamment nombreuses pour déborder hors du puits de potentiel créé sous la diffusion flottante 182, peuvent maintenant s'accumuler sous la grille G1b. On verra plus loin comment cela augmente la dynamique vers le haut. L'absence de dopage N+ sous la première grille de transfert G1a maintient une marche de potentiel accroissant la hauteur de la barrière de potentiel sous la grille G1a par rapport à la barrière sous la grille G1b lorsque les deux grilles reçoivent un même potentiel.

La figure 7 représente le chronogramme de fonctionnement associé, dans lequel on a représenté le signal TRAa commandant la mise en conduction sous la grille G1a et le signal TRAb commandant la mise en conduction sous la grille G1b. La mise en conduction par les fronts de montée de TRAa et TRAb est simultanée, pour autoriser le déversement de charges de la photodiode vers la première diffusion flottante 182. L'interruption de la conduction sous la grille G1b par le front de descente de TRAb est retardée par rapport à l'interruption de la conduction sous la grille G1a par le front de descente de TRAa. Il y a donc un moment où le potentiel sous la grille G1b est haut alors qu'il est revenu à une valeur basse sous la grille G1a. Ce chronogramme est représenté dans le cas d'un fonctionnement en mode "global shutter" dans lequel les signaux TRAa et TRAb sont globaux pour toute la matrice. Le réglage du temps d'exposition est fait globalement par le signal GR commandant la grille G5. On pourrait alternativement prévoir un réglage du temps d'exposition par la mise en conduction simultanée du transistor T1 et du transistor T3 comme expliqué précédemment. On pourrait également prévoir un mode de fonctionnement en mode "rolling shutter", de la manière expliquée précédemment mais avec deux signaux TRAa, TRAb au lieu d'un seul.

Les autres signaux sont les mêmes que ceux qui ont été expliqués en référence à la figure 4 : signal global de réinitialisation Rstg puis signal rolling de réinitialisation Rstr ; signaux rolling de sélection de ligne ; lecture par un signal d'échantillonnage SHS et un signal d'échantillonnage SHR.

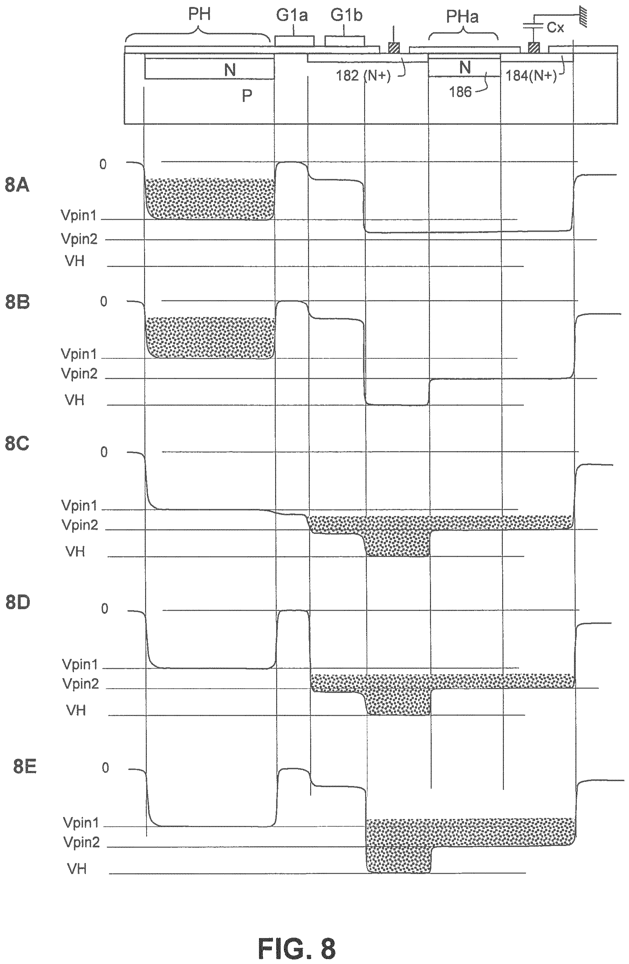

La figure 8 représente le diagramme de potentiel correspondant, tracé dans un cas où il y a un fort éclairement, le cas du faible éclairement étant identique à celui de la figure 5 sans que le front de descente décalé de la commande de la grille G1b joue un rôle significatif. Plus précisément, la figure 8A représente l'accumulation de charges dans la photodiode pendant la durée d'intégration et après la phase de hard reset du nœud de stockage selon le même principe qu'à la figure 5A. La figure 8B représente la répartition de potentiels à la fin de la phase de soft reset (fin du signal global Rstg), selon le même principe qu'à la figure 5B.

La figure 8C représente la phase de transfert pendant laquelle les deux signaux TRAa et TRAb sont simultanément portés au potentiel haut qui permet l'abaissement de la barrière de potentiel entre la photodiode et le nœud de stockage. Les charges de la photodiode se répartissent dans les trois parties du nœud de stockage, mais aussi sous la grille G1b. Au-delà des charges qui remplissent le puits de potentiel dans la première diffusion flottante, on peut encore stocker une quantité de charges égale à la différence de tension Vpin2-Vpin1 multipliée par la somme des capacités des trois parties du nœud de stockage et de la capacité sous la grille G1b. Au-delà, les charges resteraient en partie dans la photodiode et ne seraient pas transférées dans le nœud de stockage. On dépasse donc maintenant la limite de stockage qui apparaissait dans le diagramme de la figure 5D' grâce à la grille G1b.

La figure 8D représente la phase de fermeture de la grille G1a par le front de descente du signal TRAa, alors que la grille G1b reste ouverte du fait de la prolongation de durée du signal TRAb. Les charges stockées dans le nœud de stockage ne peuvent pas revenir vers la photodiode.

Enfin, la figure 8E représente la dernière phase qui est la fermeture de la barrière sous la grille G1b par le front de descente du signal TRAb. Les charges qui étaient sous la grille G1b sont repoussées vers le nœud de stockage. Et on peut voir que ces charges peuvent faire monter le potentiel du nœud de stockage au-dessus de la valeur Vpin1, ce qui n'était pas le cas à la figure 5D'.

Dans une autre variante de réalisation de l'invention, la grille de transfert entre la photodiode et le nœud de stockage comprend trois grilles partielles successives juxtaposées. Cette variante permet, comme on le verra, d'effectuer une intégration en mode global shutter tout en autorisant une lecture différentielle par double corrélation véritable dans les cas de faible éclairement.

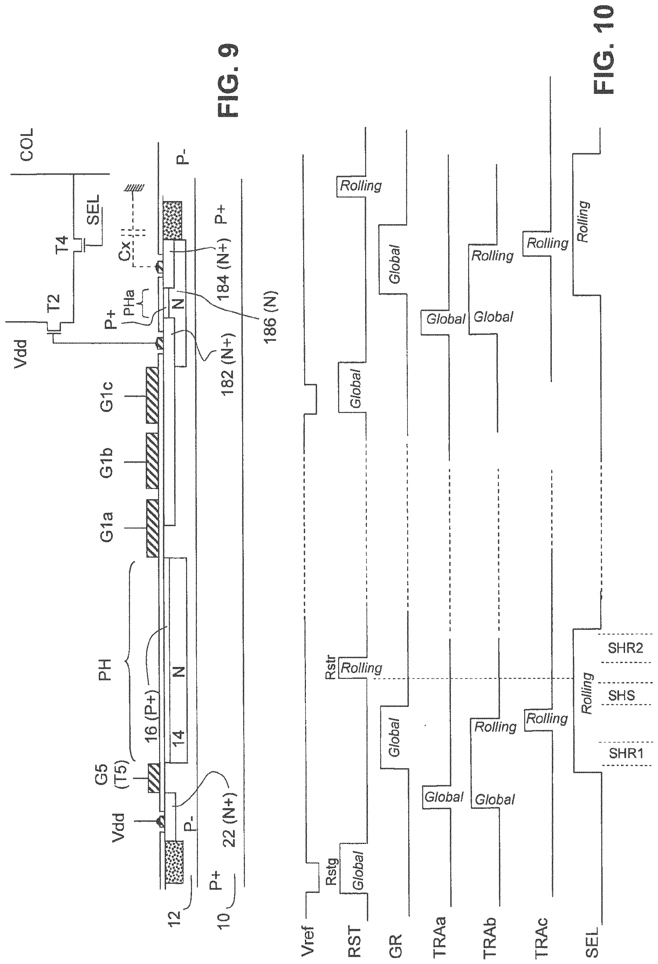

La figure 9 représente cette réalisation avec une succession de trois grilles de transfert entre la photodiode et le nœud de stockage, la première grille de transfert G1a étant adjacente à la photodiode et la troisième grille de transfert G1c étant adjacente à la première diffusion flottante. La deuxième grille de transfert G1b est située entre la première et la troisième grille de transfert. Le capteur comporte des moyens pour appliquer séparément aux différentes grilles de transfert des potentiels de commande, pour (après intégration de charges et réinitialisation du nœud de stockage par un signal global Grst) :

- d'abord abaisser la barrière de potentiel sous les première et deuxième grilles G1a et G1b par un front montant d'un signal global TRAa sur la grille de G1a, et d'un signal TRAb sur la grille de G1b, et ainsi autoriser un transfert de charges de la photodiode vers une zone située sous la deuxième grille de transfert G1b; une marche de potentiel est prévue sous la grille G1a, pour empêcher un retour de charges vers la photodiode lorsqu'une grande quantité de charges est stockée sous la grille G1b ; cette marche est obtenue par exemple par un dopage de type N qui s'étend sous les grilles G1c, G1b et en partie sous la grille G1a mais pas dans la partie où la grille G1a est adjacente à la photodiode : à cet endroit le dopage reste de type P ;

- puis remonter la barrière de potentiel sous la première grille de transfert G1a, par un front de descente global du signal TRAa, pour localiser les charges sous la deuxième grille G1b ;

- puis abaisser la barrière de potentiel présente sous la troisième grille, par un front de montée "rolling" du signal de commande TRAc de la grille G1c, et ainsi autoriser une répartition de charges entre la zone située sous la deuxième grille et la première diffusion flottante 182, ceci pour une ligne donnée de pixels ;

- élever une barrière de potentiel sous la deuxième grille G1b par un front de descente "rolling" du signal TRAb,

- et enfin élever une barrière de potentiel sous la troisième grille G1c pour la ligne considérée, par un front de descente "rolling" du signal TRAc, pour concentrer les charges dans les trois parties (182, 184, PHa, du noeud de stockage).

La figure 10 montre le chronogramme correspondant, sur lequel sont indiqués les fronts de montée et fronts de descente globaux pour toute la matrice, ainsi que ceux qui sont "rolling" pour une seule ligne à la fois. On notera tout particulièrement le signal TRAb dont le front de montée est global mais dont le front de descente est "rolling".

Trois échantillonnages sont faits, pour déterminer respectivement et dans l'ordre, pour chaque ligne puis pour les suivantes :

- échantillonnage par un signal SHR1 d'un niveau de réinitialisation du nœud de stockage après réinitialisation globale ;

- un échantillonnage par un signal SHS d'un niveau de signal utile après la fin des trois signaux TRAa, TRAb, TRAc, et avant la réinitialisation du nœud de stockage par le signal Rstr "rolling",

- un nouvel échantillonnage, par un signal SHR2, du niveau de réinitialisation du nœud de stockage, après la réinitialisation par le signal Rstr.

L'un ou l'autre des échantillonnages de niveau de réinitialisation sera utilisé, selon le cas, comme on l'expliquera plus loin.

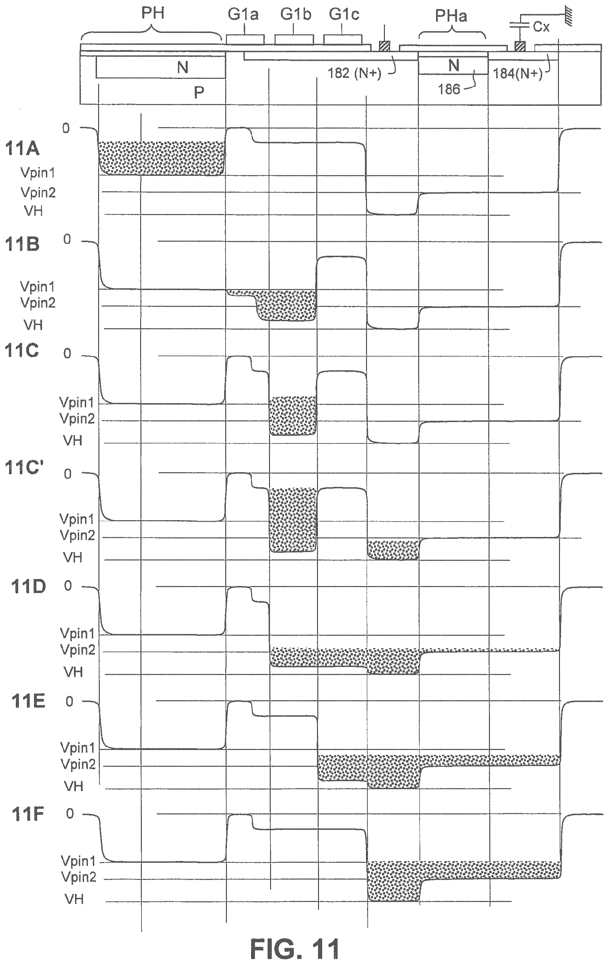

La figure 11 représente les diagrammes de potentiel successifs qui résultent de ce chronogramme.

En figure 11A, les charges générées par la lumière sont stockées dans la photodiode et la réinitialisation globale du pixel a été effectuée par le signal global Rstg, de préférence avec les deux étapes de hard reset et soft reset. Les barrières de potentiel sous les trois grilles sont hautes (signaux TRAa, TRAb, TRAc au niveau bas). On voit la marche de potentiel sous la grille G1a, établissant du côté de la photodiode une barrière de potentiel supérieure à la barrière de potentiel sous les grilles G1b et G1c.

En figure 11B, les barrières sous les grilles G1a et G1b sont abaissées simultanément et pour toute la matrice de pixels. La barrière sous la grille G1c reste haute. Les charges de la photodiode passent essentiellement sous la grille G1b.

En figure 11C, la barrière sous la grille G1a est remontée, mais pas la barrière sous la grille G1b. Les charges sont stockées sous la grille G1b dans la mesure où elles ne débordent pas.

En figure 11C', on a représenté la même situation qu'en 11C, mais dans le cas où les charges transférées sous la grille G1b sont nombreuses et débordent à travers la grille G1c vers le nœud de stockage. Ce débordement sera pris en compte comme on le verra. Les charges ne retournent pas vers la photodiode en raison de la marche de potentiel qui produit une barrière plus élevée du côté de la photodiode que du côté de la grille G1c.

A ce stade, on effectue un premier échantillonnage (SHR1) du potentiel du nœud de stockage, résultant des charges présentes dans le nœud de stockage ; dans le cas de la figure 11C, on peut constater qu'on échantillonne simplement un niveau de réinitialisation du nœud de stockage avant déversement de charges. Dans le cas de la figure 11C', on constate qu'on échantillonne un niveau correspondant aux charges qui ont débordé vers la première diffusion flottante 182 du nœud de stockage et non pas un niveau de réinitialisation.

En figure 11D, la barrière sous la troisième grille G1c est abaissée, mais uniquement pour une ligne adressée par un signal de sélection de ligne SEL. Les charges se répartissent dans le nœud de stockage et sous les grilles G1b et G1c.

En figure 11E, la barrière de potentiel sous la deuxième grille G1b est remontée, en "rolling", c'est-à-dire uniquement pour la ligne sélectionnée. Les charges se répartissent entre le nœud de stockage et la grille de transfert G1c.

En figure 11F, la barrière de potentiel sous la troisième grille G1c est remontée, en "rolling", pour la ligne sélectionnée. Les charges se concentrent uniquement dans les trois régions du nœud de stockage si elles sont suffisamment nombreuses et uniquement dans la première région si elles sont peu nombreuses.

Un deuxième échantillonnage SHS du potentiel du nœud de stockage est effectué pour la ligne considérée. Cet échantillonnage représente le potentiel du nœud de stockage résultant des charges utiles.

Enfin, le nœud de stockage est réinitialisé, en "rolling", pour la ligne considérée et un troisième échantillonnage (SHR2) du potentiel du nœud de stockage est effectué.

Si le troisième échantillonnage et le premier donnent le même résultat, c'est qu'il n'y a pas eu débordement de charges à l'étape 11C. On considère alors que l'éclairement est faible et qu'une mesure par double échantillonnage corrélé véritable est valable en faisant la soustraction entre le deuxième échantillonnage SHS et le premier SHR1.

Si au contraire les premier et troisième échantillonnages donnent des résultats différents, c'est qu'il y a eu débordement de charges à l'étape 11C', le premier échantillonnage correspondant aux charges qui ont débordé. Dans ce cas, c'est que l'éclairement est plus important et un double échantillonnage corrélé véritable ne peut pas être effectué. On détermine alors la mesure d'éclairement en faisant la différence entre le deuxième échantillonnage SHS (qui correspond à la somme des charges transférées, incluant celles qui ont débordé) et le troisième SHR2 (qui correspond à un niveau de réinitialisation après lecture des charges utiles puis réinitialisation par le signal rolling Rstr).

On effectue donc une comparaison entre les première et troisième lecture du niveau de potentiel de la première diffusion flottante, pour établir une mesure par différence entre la deuxième lecture et la première lecture ou une mesure par différence entre la deuxième lecture et la troisième lecture selon le résultat de la comparaison.

Ainsi, l'utilisation de trois grilles de transfert permet de faire un double échantillonnage corrélé pour les faibles niveaux de lumière et c'est ce qu'on souhaite puisque le double échantillonnage corrélé permet de réduire le bruit kTC particulièrement gênant à faible niveau d'éclairement. Ce double échantillonnage corrélé est compatible avec le fonctionnement en mode "global shutter" qui a été décrit et avec un réglage de temps d'intégration à volonté par le signal GR.

On peut prévoir que le signal global TRAa est répété plusieurs fois pendant que le signal TRAb est actif.

Enfin, comme on l'a dit précédemment, la deuxième diffusion flottante n'est pas adjacente à la grille de réinitialisation G3 et c'est la première diffusion flottante qui est adjacente à cette grille pour permettre la réinitialisation du pixel au cours de chaque cycle d'intégration et lecture. Toutefois, on peut prévoir une grille de réinitialisation supplémentaire, non représentée, adjacente à la deuxième diffusion flottante et permettant de vider vers un drain les charges de cette deuxième diffusion flottante, non pas au cours du fonctionnement normal mais uniquement pour un mode de calibration, par exemple à la première utilisation du capteur ou à chaque nouvelle alimentation du capteur. On effectue un cycle d'intégration et transfert en présence de lumière éclairant toute la matrice. On réinitialise alors le nœud de stockage par la deuxième diffusion flottante sans vider les charges qui remplissent jusqu'au niveau Vpin2 la première diffusion flottante, on lit les niveaux de réinitialisation de tous les pixels (lecture ligne à ligne du niveau de potentiel de la première diffusion flottante, pour chaque pixel) et on les stocke dans une table de correction qui servira ultérieurement à corriger les dispersions de niveau Vpin2 de pixel à pixel.

**Revendications**

1. Capteur d'image comprenant une matrice de pixels actifs, chaque pixel comprenant une photodiode (PH) à potentiel interne intrinsèque fixe, un nœud de stockage (ND) pour un stockage de charges intégrées dans la photodiode, au moins une grille (G1) de transfert de charges entre la photodiode et le nœud de stockage pour commander le transfert de charges de la photodiode vers le nœud de stockage après une phase de réinitialisation du nœud de stockage, une grille (G3) de réinitialisation du potentiel du nœud de stockage, et une connexion électrique entre le nœud de stockage et la grille d'un transistor de lecture (T2), pour permettre une mesure du potentiel du nœud de stockage pendant une phase de lecture suivant la phase de réinitialisation, **caractérisé en ce que** le nœud de stockage comporte trois parties comprenant :

   - une première diffusion flottante (182) adjacente à la grille de transfert et à la grille de réinitialisation, et reliée par la connexion électrique à la grille du transistor de lecture,
   - une deuxième diffusion flottante (184), non adjacente à la première diffusion flottante, non adjacente à la grille de réinitialisation, non reliée à la grille du transistor de lecture,
   - une structure de fixation de potentiel interne (PHa), séparant la première diffusion flottante de la deuxième diffusion flottante, cette structure établissant un plateau de potentiel interne en l'absence de charges entre les deux diffusions flottantes et dans la deuxième diffusion flottante, à un niveau de potentiel intermédiaire (Vpin2) fixe pendant la phase de lecture, supérieur au potentiel interne intrinsèque fixe (Vpin1) de la photodiode mais inférieur à un niveau de potentiel de réinitialisation (VH) de la première diffusion flottante, de sorte que les charges déversées depuis la photodiode dans le nœud de stockage soient confinées dans la première diffusion flottante mais débordent spontanément, si elles sont trop nombreuses, dans la structure de fixation de potentiel interne et dans la deuxième diffusion flottante.

2. Capteur d'image selon la revendication 1, **caractérisé en ce qu'**une capacité auxiliaire (Cx) faisant partie du pixel est reliée par une connexion électrique à la deuxième diffusion flottante.

3. Capteur d'image selon l'une des revendications 1 et 2, **caractérisé en ce que** la grille de transfert de charges est composée d'une succession d'au moins deux grilles de transfert (G1a, G1b) entre la photodiode et le nœud de stockage, la première grille de transfert étant adjacente à la photodiode et la dernière grille de transfert étant adjacente à la première diffusion flottante, et **en ce que** le capteur comporte des moyens pour appliquer séparément aux différentes grilles de transfert des potentiels de commande, pour d'abord autoriser un transfert de charges de la photodiode vers la première diffusion flottante, puis élever une barrière de potentiel d'abord sous la première grille de transfert et enfin élever une barrière de potentiel sous la dernière grille de transfert.

4. Capteur d'image selon l'une des revendications 1 et 2, **caractérisé en ce que** la grille de transfert est composée d'une succession de trois grilles de transfert (G1a, G1b, G1c) entre la photodiode et le nœud de stockage, la première grille de transfert (G1a) étant adjacente à la photodiode et la troisième grille de transfert (G1c) étant adjacente à la première diffusion flottante, et la deuxième grille de transfert (G1b) étant située entre la première et la troisième grille de transfert, et **en ce que** le capteur comporte des moyens pour appliquer séparément aux différentes grilles de transfert des potentiels de commande, pour d'abord autoriser par la première grille de transfert un transfert de charges de la photodiode vers une zone située sous la deuxième grille de transfert, puis établir une barrière de potentiel sous la première grille de transfert, puis successivement autoriser le transfert de charges de la zone située sous la deuxième grille vers la première diffusion flottante, et enfin élever une barrière de potentiel sous la deuxième et la troisième grilles de transfert.

5. Capteur d'image selon la revendication 4, **caracté-**

**risé en ce qu'**il comporte des moyens pour effectuer dans l'ordre une réinitialisation globale des potentiels du nœud de stockage par une activation de la grille de réinitialisation, et une autorisation globale par la première et la deuxième grilles de transfert d'un transfert de charges de la photodiode vers la zone située sous la deuxième grille de transfert suivie d'une inhibition globale de ce transfert, puis ligne par ligne,

- une première lecture du niveau de potentiel de la première diffusion flottante,
- un transfert de charges de la zone située sous la deuxième grille de transfert vers la première diffusion flottante et éventuellement la deuxième diffusion flottante,
- une deuxième lecture du niveau de potentiel de la première diffusion flottante,
- une réinitialisation du potentiel de la première diffusion flottante,
- une troisième lecture du niveau de potentiel de réinitialisation de la première diffusion flottante,
- et une comparaison entre les première et troisième lecture pour établir une mesure par différence entre la deuxième lecture et la première lecture ou une mesure par différence entre la deuxième lecture et la troisième lecture selon le résultat de la comparaison.

6. Capteur d'image selon l'une des revendications 1 à 5, **caractérisé en ce que** la structure (PHa) établissant un plateau de potentiel à niveau de potentiel interne fixe séparant la première diffusion flottante de la deuxième diffusion flottante, est une diode à potentiel interne intrinsèque fixe, dont le potentiel interne intrinsèque fixe est supérieur au potentiel interne intrinsèque fixe de la photodiode.

7. Capteur d'image selon l'une des revendications 1 à 5, **caractérisé en ce que** la structure (PHa) établissant un plateau de potentiel à niveau de potentiel interne fixe séparant la première diffusion flottante de la deuxième diffusion flottante, est une grille portée un potentiel fixe créant une barrière de potentiel de niveau supérieur au potentiel interne intrinsèque fixe de la photodiode.

8. Capteur d'image selon l'une quelconque des revendications précédentes, **caractérisé en ce qu'**il comporte une autre grille de réinitialisation, cette autre grille est adjacente à la deuxième diffusion flottante (184), et est prévue pour permettre une réinitialisation globale des potentiels du nœud de stockage via la deuxième diffusion flottante, sans vider les charges contenues dans la première diffusion flottante, puis une lecture ligne à ligne du niveau de potentiel de la première diffusion flottante, permettant d'obtenir et stocker le niveau de réinitialisation de chaque pixel dans une phase de calibration.

**Patentansprüche**

1. Bildsensor, der eine Matrix von aktiven Pixeln umfasst, wobei jedes Pixel eine Photodiode (PH) mit einem festen intrinsischen internen Potential, einen Speicherknoten (ND) zum Speichern von in der Photodiode integrierten Ladungen, mindestens ein Gate (G1) für den Transfer von Ladungen zwischen der Photodiode und dem Speicherknoten zum Steuern des Transfers von Ladungen von der Photodiode zum Speicherknoten nach einer Neuinitialisierungsphase des Speicherknotens, ein Gate (G3) zum Neuinitialisieren des Potentials des Speicherknotens und eine elektrische Verbindung zwischen dem Speicherknoten und dem Gate eines Lesetransistors (T2) umfasst, um eine Messung des Potentials des Speicherknotens während einer Lesephase nach der Neuinitialisierungsphase zu ermöglichen, **dadurch gekennzeichnet, dass** der Speicherknoten drei Teile aufweist, die Folgendes umfassen:

   - eine erste schwebende Diffusion (182) neben dem Transfergate und dem Neuinitialisierungsgate, die über die elektrische Verbindung mit dem Gate des Lesetransistors verbunden ist,
   - eine zweite schwebende Diffusion (184) nicht neben der ersten schwebenden Diffusion, nicht neben dem Neuinitialisierungsgate und nicht mit dem Gate des Lesetransistors verbunden,
   - eine Struktur (PHa) zum Fixieren des internen Potentials, die die erste schwebende Diffusion von der zweiten schwebenden Diffusion trennt, wobei diese Struktur ein internes Potentialplateau in Abwesenheit von Ladungen zwischen den beiden schwebenden Diffusionen und in der zweiten schwebenden Diffusion auf einem festen Zwischenpotentialpegel (Vpin2) während der Lesephase einrichtet, das höher als das feste intrinsische interne Potential (Vpin1) der Photodiode, aber niedriger als ein Neuinitialisierungspotentialpegel (VH) der ersten schwebenden Diffusion ist, so dass die von der Photodiode in den Speicherknoten abgeführten Ladungen in der ersten schwebenden Diffusion eingeschlossen sind, aber, wenn sie zu zahlreich sind, spontan in die Struktur zum Fixieren des internen Potentials und in die zweite schwebende Diffusion überlaufen.

2. Bildsensor nach Anspruch 1, **dadurch gekennzeichnet, dass** eine Hilfskapazität (Cx), die Teil des Pixels bildet, durch eine elektrische Verbindung mit der zweiten schwebenden Diffusion verbunden ist.

3. Bildsensor nach einem der Ansprüche 1 und 2, **da-**

**durch gekennzeichnet, dass** das Ladungstransfergate aus einer Folge von mindestens zwei Transfergates (G1a, G1b) zwischen der Photodiode und dem Speicherknoten zusammengesetzt ist, wobei sich das erste Transfergate neben der Photodiode und das letzte Transfergate neben der ersten schwebenden Diffusion befindet, und dadurch, dass der Sensor Mittel zum separaten Anlegen von Steuerpotentialen an die verschiedenen Transfergates aufweist, um zunächst einen Ladungstransfer von der Photodiode zur ersten schwebenden Diffusion zu ermöglichen, dann eine Potentialbarriere zunächst unter dem ersten Transfergate und schließlich eine Potentialbarriere unter dem letzten Transfergate zu erhöhen.

4. Bildsensor nach einem der Ansprüche 1 und 2, **dadurch gekennzeichnet, dass** das Transfergate aus einer Folge von drei Transfergates (Gla, G1b, G1c) zwischen der Photodiode und dem Speicherknoten zusammengesetzt ist, wobei sich das erste Transfergate (G1a) neben der Photodiode und das dritte Transfergate (G1c) neben der ersten schwebenden Diffusion befindet und das zweite Transfergate (G1b) sich zwischen dem ersten und dritten Transfergate befindet, und dadurch, dass der Sensor Mittel zum separaten Anlegen von Steuerpotentialen an die verschiedenen Transfergates aufweist, um zunächst über das erste Transfergate einen Ladungstransfer von der Photodiode zu einer unter dem zweiten Transfergate befindlichen Zone zu ermöglichen, dann eine Potentialbarriere unter dem ersten Transfergate einzurichten, dann nacheinander den Ladungstransfer von der unter dem zweiten Gate befindlichen Zone zur ersten schwebenden Diffusion zu ermöglichen und schließlich eine Potentialbarriere unter dem zweiten und dritten Transfergate zu erhöhen.

5. Bildsensor nach Anspruch 4, **dadurch gekennzeichnet, dass** er Mittel aufweist, um der Reihe nach eine globale Neuinitialisierung der Potentiale des Speicherknotens durch Aktivieren des Neuinitialisierungsgates und eine globale Autorisierung eines Ladungstransfers von der Photodiode zu der unter dem zweiten Transfergate befindlichen Zone durch das erste und zweite Transfergate, gefolgt von einer globalen Hemmung dieses Transfers, dann Zeile für Zeile Folgendes durchzuführen:

   - ein erstes Lesen des Potentialpegels der ersten schwebenden Diffusion,
   - einen Ladungstransfer von der unter dem zweiten Transfergate befindlichen Zone zur ersten schwebenden Diffusion und eventuell zur zweiten schwebenden Diffusion,
   - ein zweites Lesen des Potentialpegels der ersten schwebenden Diffusion,

- ein Neuinitialisieren des Potentials der ersten schwebenden Diffusion,
- ein drittes Lesen des Neuinitialisierungspotentialpegels der ersten schwebenden Diffusion,
- und einen Vergleich zwischen dem ersten und dritten Ablesewert, um eine Messung anhand der Differenz zwischen dem zweiten Ablesewert und dem ersten Ablesewert oder eine Messung anhand der Differenz zwischen dem zweiten Ablesewert und dem dritten Ablesewert gemäß dem Ergebnis des Vergleichs zu erstellen.

6. Bildsensor nach einem der Ansprüche 1 bis 5, **dadurch gekennzeichnet, dass** die Struktur (PHa), die ein Potentialplateau mit einem festen internen Potentialpegel bildet, das die erste schwebende Diffusion von der zweiten schwebenden Diffusion trennt, eine Diode mit einem festen intrinsischen internen Potential ist, deren festes intrinsisches internes Potential höher ist als das feste intrinsische interne Potential der Photodiode.

7. Bildsensor nach einem der Ansprüche 1 bis 5, **dadurch gekennzeichnet, dass** die Struktur (PHa), die ein Potentialplateau mit einem festen internen Potentialpegel bildet, das die erste schwebende Diffusion von der zweiten schwebenden Diffusion trennt, ein Gate ist, das ein festes Potential trägt, das eine Potentialbarriere mit einem Pegel bildet, der höher ist als das feste intrinsische interne Potential der Photodiode.

8. Bildsensor nach einem der vorherigen Ansprüche, **dadurch gekennzeichnet, dass** er ein weiteres Neuinitialisierungsgate aufweist, dieses andere Gate sich neben der zweiten schwebenden Diffusion (184) befindet und zum Ermöglichen einer globalen Neuinitialisierung der Potentiale des Speicherknotens über die zweite schwebende Diffusion, ohne die in der ersten schwebenden Diffusion enthaltenen Ladungen zu entleeren, dann eines zeilenweisen Ablesens des Potentialpegels der ersten schwebenden Diffusion ausgelegt ist, die es ermöglicht, den Neuinitialisierungspegel jedes Pixels in einer Kalibrierungsphase zu erhalten und zu speichern.

**Claims**

1. Image sensor comprising a matrix of active pixels, each pixel comprising a photodiode (PH) with a set intrinsic internal potential, a storage node (ND) for storing charges integrated in the photodiode, at least one gate (G1) for transferring charges between the photodiode and the storage node for controlling the transfer of charges from the photodiode to the storage node after a phase of resetting the storage node, a gate (G3) for resetting the potential of the storage node, and an electrical connection between the storage node and the gate of a read-out transistor (T2), in order to allow the potential of the storage node to be read-out in a read-out phase following the reset phase, **characterized in that** the storage node includes three portions comprising:

- a first floating diffusion (182) that is adjacent to the transfer gate and to the reset gate, and connected by the electrical connection to the gate of the read-out transistor,
- a second floating diffusion (184) that is not adjacent to the first floating diffusion, not adjacent to the reset gate and not connected to the gate of the read-out transistor,
- a structure (PHa) for setting internal potential, separating the first floating diffusion from the second floating diffusion, this structure establishing, in the absence of charges, an internal potential plateau between the two floating diffusions and in the second floating diffusion, at an intermediate potential level (Vpin2) that is constant during the read-out phase and higher than the set intrinsic internal potential (Vpin1) of the photodiode but lower than a reset potential level (VH) of the first floating diffusion, so that the charges transferred from the photodiode into the storage node are confined in the first floating diffusion but spontaneously overflow, if they are too many, into the structure for setting internal potential and into the second floating diffusion.

2. Image sensor according to claim 1, **characterized in that** an auxiliary capacitance (Cx) forming part of the pixel is connected by an electrical connection to the second floating diffusion.

3. Image sensor according to one of claims 1 and 2, **characterized in that** the gate for transferring charges is composed of a succession of at least two transfer gates (Gla, G1b) between the photodiode and the storage node, the first transfer gate being adjacent to the photodiode and the last transfer gate being adjacent to the first floating diffusion, and **in that** the sensor includes means for applying control potentials to the various transfer gates separately, in order firstly to permit a transfer of charges from the photodiode to the first floating diffusion, then a potential barrier to be raised firstly under the first transfer gate and lastly a potential barrier to be raised under the last transfer gate.

4. Image sensor according to one of claims 1 and 2, **characterized in that** the transfer gate is composed of a succession of three transfer gates (Gla, G1b, G1c) between the photodiode and the storage node, the first transfer gate (G1a) being adjacent to the photodiode and the third transfer gate (G1c) being adjacent to the first floating diffusion, and the second transfer gate (G1b) being located between the first and third transfer gates, and **in that** the sensor includes means for applying control potentials to the various transfer gates separately, in order firstly to permit, via the first transfer gate, charges to be transferred from the photodiode to a zone located under the second transfer gate, then a potential barrier to be established under the first transfer gate, then in succession to permit charges to be transferred from the zone located under the second gate to the first floating diffusion, and lastly a potential barrier to be raised under the second and third transfer gates.

5. Image sensor according to claim 4, **characterized in that** it includes means for performing, in order, a global reset of the potentials of the storage node by activation of the reset gate, and, via the first and second transfer gates, a global authorisation of a transfer of charges from the photodiode to the zone located under the second transfer gate, followed by a global inhibition of this transfer,
then row by row,

   - a first read-out of the potential level of the first floating diffusion;
   - a transfer of charges from the zone located under the second transfer gate to the first floating diffusion and possibly the second floating diffusion;
   - a second read-out of the potential level of the first floating diffusion;
   - a reset of the potential of the first floating diffusion;
   - a third read-out of the reset potential level of the first floating diffusion;
   - and a comparison of the first and third read-outs in order to establish, depending on the result of this comparison, a measurement of the difference between the second read-out and the first read-out or a measurement of the difference between the second read-out and the third read-out.

6. Image sensor according to one of claims 1 to 5, **characterized in that** the structure (PHa) establishing a potential plateau of constant internal potential level separating the first floating diffusion from the second floating diffusion is a diode of set intrinsic internal potential, the set intrinsic internal potential of which is higher than the set intrinsic internal potential of the photodiode.

7. Image sensor according to one of claims 1 to 5, **characterized in that** the structure (PHa) establishing a potential plateau of constant internal potential level separating the first floating diffusion from the second floating diffusion is a gate biased to a set potential creating a potential barrier of level higher than the set intrinsic internal potential of the photodiode.

8. Image sensor according to any one of the preceding claims, **characterized in that** it includes another reset gate, this other gate being adjacent to the second floating diffusion (184), and is provided to allow a global reset of the potential of the storage node via the second floating diffusion without needing to empty the charges contained in the first floating diffusion, then, a row-by-row read-out of the potential level of the first floating diffusion, allowing the reset level of each pixel to be obtained and stored in a calibrating phase.

EP 3 308 399 B1

**FIG. 1**

**FIG. 2**

**FIG. 3**

**FIG. 4**

FIG. 5

FIG. 6

FIG. 7

FIG. 8

FIG. 9

FIG. 10

FIG. 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130001404 A
- US 2007257280 A
- US 20140103189 A
- EP 2346079 A
- EP 1868377 A